Europäisches Patentamt

European Patent Office

Office européen des brevets

(19)

(11) **EP 1 435 761 A1**

(12) **EUROPEAN PATENT APPLICATION**
published in accordance with Art. 158(3) EPC

(43) Date of publication:
**07.07.2004 Bulletin 2004/28**

(21) Application number: **02765518.2**

(22) Date of filing: **12.09.2002**

(51) Int Cl.7: **H05B 33/02**, H05B 33/14,
H05B 3/22, G02B 1/10,
G09F 9/00, G09F 9/30

(86) International application number:
**PCT/JP2002/009372**

(87) International publication number:
**WO 2003/026356 (27.03.2003 Gazette 2003/13)**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **12.09.2001 JP 2001276422**

(71) Applicant: **Nissan Chemical Industries, Ltd.
Chiyoda-ku, Tokyo 101-0054 (JP)**

(72) Inventors:
• **OOTSUKA, Y.,
c/o Nissan Chemical Industries, Ltd.
Tokyo 101-0054 (JP)**

• **ABE, T., c/o Nissan Chemical Industries, Ltd.
Tokyo 101-0054 (JP)**
• **MOTOYAMA, K.,
c/o Nissan Chemical Industries,Ltd.
Funabashi-shi, Chiba 274 (JP)**

(74) Representative: **Hartz, Nikolai F., Dr. et al
Wächtershäuser & Hartz
Patentanwälte
Weinstrasse 8
80333 München (DE)**

(54) **ORGANIC ELECTROLUMINESCENCE ELEMENT&minus;USE TRANSPARENT SUBSTRATE AND ELEMENT**

(57)    The present invention provides a transparent substrate capable of improving the light extraction efficiency of an organic electroluminescence device, and an organic electroluminescence device with high luminous efficiency and with excellent mass productivity using the substrate.

The present invention relates to a transparent substrate for an organic electroluminescence device characterized in that an optical interference film comprising at least one layer having such a refractive index and a film thickness as to reduce a quantity of reflection of light emitted from a light-emitting layer is provided on both sides of the transparent substrate in the organic electroluminescence device, and to an organic electroluminescence device comprising the transparent substrate.

## Fig. 1

EP 1 435 761 A1

## Description

TECHNICAL FIELD

The present invention relates to a substrate for an organic electroluminescence device, and an organic electroluminescence device using it.

BACKGROUND ART

The organic electroluminescence devices are devices newly getting attention with recent increasing demand for flat displays. A device configuration proposed by Tang and Vanslyke is one consisting of an anode, a hole transporting layer, an electron transporting light-emitting layer, and a cathode formed on a glass substrate (Appl. Phys. Lett., 51, 913, 1987). Other known devices include a device achieving lightweight and flexible natures by using a film substrate in place of the glass substrate (Semiconductor FPD World 2001, 6, 152), a device adopting a top emission scheme wherein the cathode in the above device configuration is made of a transparent material and a transparent film is placed thereon, so as to extract light from the cathode side (Semiconductor FPD World 2001, 4, 136), and so on. The organic electroluminescence devices have advantages over the liquid crystal devices commonly used heretofore as flat panel displays.

Namely, the advantages are less viewing angle dependence by virtue of self-emitting devices, low power consumption, and capability of formation of extremely thin devices. However, they still have many problems to be solved, in order to be applied to flat displays. One of the problems is a short emission lifetime of the device. A present solution to this is an improvement in the material of the light-emitting layer out of the components of the device to achieve the lifetime of approximately ten thousand hours, which is less than a satisfactory lifetime for application of this device to the flat displays. The reason is that if a still image is displayed over a long period of time on a flat display in application of the short-lifetime device, there occurs an image retention phenomenon in which the difference in luminance between on pixels and off pixels is visually recognized as an after image.

There are a lot of factors associated with the emission lifetime, but it is known that the lifetime becomes shorter as a higher voltage is applied to the device in order to enhance the luminance of emission. However, the luminance of emission of the display using the organic electroluminescence device is not satisfied by application of a low voltage, but on the contrary the luminance of emission has to be increased by applying a high voltage to the device, in order to secure visibility of the display outdoors during the day. As described above, the organic electroluminescence devices faced with such a dilemma that the luminance of emission needed to be lowered in order to lengthen the lifetime, whereas the lifetime became shorter with enhancement of visibility.

In order to solve this problem, improvements have energetically been made heretofore in the material of the light-emitting layer in the organic electroluminescence devices. Namely, attempts were made to develop the materials of the light-emitting layer with high internal energy efficiency, in order to achieve a high luminance of emission with application of a lower voltage.

On the other hand, Thompson et al. teach that the external energy efficiency indicating the luminous efficiency of the organic electroluminescence device can be expressed by the product of the internal energy efficiency and light extraction efficiency of the device (Optics Letters 22, 6, 396, 1997). Namely, it is necessary to increase not only the internal energy efficiency but also the light extraction efficiency, in order to increase the luminous efficiency of the organic electroluminescence device.

The light extraction efficiency is a rate of light released from the front face of the transparent substrate of the device into the atmosphere to light emitted in the device. Namely, the light emitted in the light-emitting layer needs to pass through interfaces between some media with different indices of refraction before released into the atmosphere, and, according to the Snell's law of refraction, light incident at angles equal to or greater than the critical angle to each interface is totally reflected by the interface to propagate and dissipate in the layer or to be released through the side face of the layer, so that the light released from the front face of the device is decreased by that degree.

The foregoing Thompson et al. describe that the light extraction efficiency of the organic electroluminescence device is about 0.175, which means that approximately 18% of the light emitted in the light-emitting layer is extracted to the outside of the device but the rest, about 82%, is confined in the device to dissipate or is released from the side face of the device.

For this reason, a significant issue is to increase the light extraction efficiency and a variety of attempts have been made heretofore. The devices disclosed so far include one in which grain boundaries are formed in the transparent electrode or in the light-emitting layer so as to scatter visible light (JP-B-3-18320), one in which a glass substrate with one surface being roughened is used as a transparent substrate to scatter the light (JP-A-61-156691), and one in which a scattering region is provided in the vicinity of the interface between the electrode and the organic layer (JP-A-9-129375). However, these attempts all involve a risk of making the thickness of each layer of the device uneven and it can be the cause to induce dielectric breakdown and unevenness of emission of the device; therefore, those attempts were not satisfactory in terms of mass productivity of the device.

Other devices disclosed heretofore include those in which an antireflection treatment such as an optical interference film is provided between the transparent substrate and the light-emitting layer (JP-A-2-56892 and JP-A-3-297090). However, these demonstrate the effect in inorganic electroluminescence devices with large refractive indices, but, in the case of the organic electroluminescence devices with relatively small refractive indices, they fail to achieve satisfactory effect, because the total reflection poses a significant issue not only on the interface between the transparent substrate and the emitting-layer-side transparent electrode but also on the interface between the transparent substrate and the atmosphere.

For that matter, the above inventions are aimed at preventing the ambiemt light from passing through the transparent substrate and being reflected by the mirror-finished electrode on the back side of the device so as to degrade the display quality of the device such as contrast, and are thus significantly different in setting of the refractive index and thickness of the film in terms of extraction of light.

Therefore, the problem of low light extraction efficiency of the organic electroluminescence device still remains unsolved.

The present invention has been accomplished on the basis of the above-stated background and an object thereof is to provide a transparent substrate capable of achieving an improvement in the light extraction efficiency of the organic electroluminescence device and to provide an organic electroluminescence device with high luminous efficiency and with excellent mass productivity using the substrate.

## DISCLOSURE OF THE INVENTION

The present invention provides a transparent substrate for an organic electroluminescence device having the following features, and an organic electroluminescence device using it.

(1) A transparent substrate for an organic electroluminescence device, wherein an optical interference film comprising at least one layer having such a refractive index and a film thickness as to reduce a quantity of reflection of light emitted from a light-emitting layer is provided on both sides of the transparent substrate.

(2) The transparent substrate according to the above (1), wherein the optical interference film has the refractive index of from 1.1 to 2.3 and the film thickness of from 10 to 25,000 nm.

(3) The transparent substrate according to the above

(1) or (2), wherein the optical interference film is a multilayer film comprising a high refractive index film and a low refractive index film, or a multilayer film comprising films of different thicknesses.

(4) The transparent substrate according to the above (1), (2), or (3), wherein the optical interference film is one obtained by applying a sol-gel material of a metal oxide onto the transparent substrate and baking the material.

(5) The transparent substrate according to the above (4), wherein the sol-gel material of the metal oxide is one resulting from polycondensation of a metal alkoxide in an organic solvent in the presence of an acidic compound or a basic compound.

(6) The transparent substrate according to the above (5), wherein the metal alkoxide is an alkoxysilane or a tetraalkoxy compound of titanium, zirconium, aluminum, or tantalum.

(7) The transparent substrate according to any one of the above (1) to (6), wherein the optical interference film is one obtained by forming a film of a sol-gel material of a metal oxide on both sides of the transparent substrate by a dip method and baking the film.

(8) The transparent substrate according to any one of the above (1) to (7), wherein the transparent substrate is a silica glass, a soda glass, or an organic film.

(9) An organic electroluminescence device comprising the transparent substrate as defined in any one of the above (1) to (8).

## BRIEF DESCRIPTION OF THE DRAWINGS

Fig. 1 is a sectional view showing an application of the transparent substrate according to the present invention to the organic electroluminescence device.
Fig. 2 is a sectional view showing an illustration of internal confinement of light from the light-emitting layer in a case using a conventional transparent substrate.
Fig. 3 is a sectional view showing an illustration of extraction from the front face of the substrate, of light from the light-emitting layer in a case using the transparent substrate according to the present invention. Description of Reference Symbols

1. Transparent substrate
2. Transparent electrode
3. Organic layer having the light-emitting layer
4. Electrode
5. Light reflected on the interface between the transparent electrode and the transparent substrate and propagating in the device
6. Light reflected on the interface between the transparent substrate and the atmosphere and propagating in the device
7. Light not totally reflected on the interfaces, so as to be extracted from the device
8a and 8b. Optical interference layers according to the present invention

9. Transparent substrate for the organic electroluminescence device according to the present invention

10. Light extracted to the outside of the device by action of the optical interference layers according to the present invention

11. Light extracted to the outside of the device by action of the optical interference layers according to the present invention

$\theta_1$. Angle of total reflection on the interface between the transparent electrode and the transparent substrate

$\theta_2$. Angle of total reflection on the interface between the transparent substrate and the atmosphere

BEST MODE FOR CARRYING OUT THE INVENTION

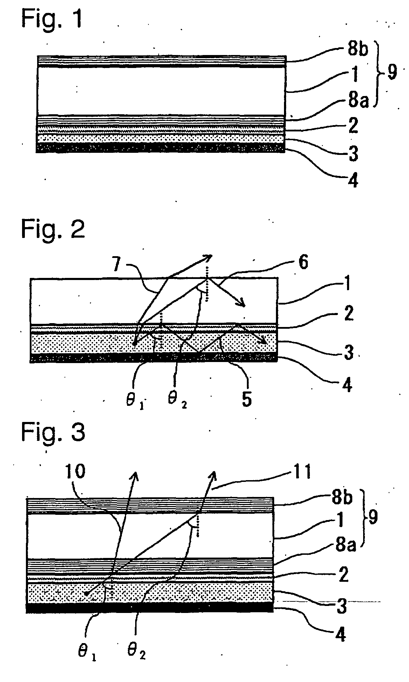

An example of the organic electroluminescence device using the transparent substrate of the present invention is shown in Fig. 1. The device in the configuration of Fig. 1 is normally fabricated by successively depositing a transparent electrode 2, an organic layer 3 including a light-emitting layer, and an electrode 4 on a transparent substrate 9 according to the present invention. Since these deposited layers are very thin, they may cause dielectric breakdown if the surface of the transparent substrate is rough. Therefore, the device-side surface of the transparent substrate 9 according to the present invention needs to be smoothed well.

The present invention is also applicable to the device configuration of the top emission scheme, and in this scheme the light-emitting device is formed on another substrate and thereafter combined with the transparent substrate 9 according to the present invention.

In use of the transparent substrate 9 with the optical interference films according to the present invention, as to light which is emitted from the light-. emitting layer 3 of the organic electroluminescence device and which is incident at an angle near the normal to the transparent substrate 9, interference occurs to reduce reflected light, because the phases of the reflected light and incident light on each film interface are reverse to each other; whereas transmitted light increases by that degree according to the momentum conservation law of light on the interface. For this reason, it becomes feasible to extract a greater quantity of light from the front face of the transparent substrate.

On the other hand, in a case using a conventional transparent substrate 1 without optical interference films as shown in Fig. 2, light 5 incident at angles equal to or greater than the critical angle $\theta_1$ to the transparent substrate 1 among the light generated by the light-emitting layer 3, is totally reflected. The totally reflected light is again totally reflected on another electrode surface 4, and through repetitions of this process the light propagates in the device to dissipate. Even light incident at angles below the critical angle $\theta_1$ into the transparent substrate 1 is again subject to reflection and refraction on the interface between the transparent substrate and the atmosphere, and light 6 incident at angles equal to or greater than the critical angle $\theta_2$ is totally reflected and propagates in the transparent substrate 1, so as to result in failure in extracting the light from the front face of the substrate.

In contrast, the use of the transparent substrate with the optical interference films 8 according to the present invention enables the extraction of some portion of the light from the front face of the transparent substrate, as shown in Fig. 3, even if the light is incident at angles equal to or greater than the critical angles $\theta_1$ and $\theta_2$ from the light-emitting layer to the interfaces with the transparent substrate, though the principle still remains unclear at this stage. Accordingly, the external luminous efficiency of the ordinary organic electroluminescence devices can be largely increased by merely using the transparent substrate according to the present invention and, in turn, it becomes feasible to achieve both the satisfactory emission luminance and lifetime of the organic electroluminescence devices as described previously.

Since the transparent substrate according to the present invention is of the structure with the optical interference films on both sides, it has the advantage that a coating method capable of producing a large-area substrate at low cost, such as a dip method, can be applied.

The transparent substrate applied to the present invention is a transparent substrate such as a silica glass, a soda glass, or an organic film. The substrate may be one with a color filter or a black matrix on the surface thereof. An optical interference film comprising at least one layer having such a refractive index and thickness as to decrease the quantity of reflection of the light emitted from the light-emitting device is formed on both sides of this transparent substrate. For example, in a case where the optical interference films of single-layer structure are provided, their thickness and refractive index are set so as to minimize the reflectance on the basis of the formula below.

$$R = \{(n^2 - n_g \times n_t) \div (n^2 + n_g \times n_t)\}^2$$

The transparent substrate is in contact with the transparent electrode while forming a reflective interface, and conditions for zeroing reflection at a specific wavelength $\lambda$ with a monolayer film being placed on the interface are $n = (n_g \times n_t)^{1/2}$ and $n \times d = (\lambda \div 4) \times N$, where d is the thickness of the optical interference film, n the refractive index thereof, $n_g$ the refractive index of the transparent substrate, $n_t$ the refractive index of the transparent electrode, and N an arbitrary natural number. In application to the antireflection film of the display, the reflection over the entire visible light region is taken into consideration, and thus λ is normally set based on 520 nm being the center wavelength. In the present invention N is normally used in the range of 1 to 50.

The above formulas indicate that it is necessary to satisfy the amplitude condition that the refractive index of the film is a square root of the refractive index of the substrate and the phase condition that the optical thickness of the film is N times quarter of the center wavelength. For example, supposing the refractive index of the transparent substrate is 1.5 and the refractive index of the transparent electrode is 2.0, the refractive index of the monolayer film to be used should be 1.73. In addition, supposing the center wavelength is set at 520 nm, nxd=130 nm and the thickness of the monolayer film can be set to N times about 75 nm. As described, the optical interference films according to the present invention normally have the refractive index preferably in the range of 1.1 to 2.3 and particularly preferably in the range of 1.2 to 1.9. The thickness of the films is normally preferably N times 10-500 nm and particularly preferably N times 50-200 nm; normally, the thickness falls preferably in the range of 10 to 25,000 nm and particularly preferably in the range of 50 to 10,000 nm.

It is also possible to use multilayer films such as double-layer films, for the purpose of controlling the reflection at a relatively low level in a wider wavelength range. There are two preferred configurations of the double-layer films. One of them is a sequential stack of a high refractive index film and a low refractive index film, the difference between refractive indices of which is preferably 0.01-1.00 and the thicknesses of which are set so as to hold down the reflectances on the respective films. The other is a type in which the structure is the same but the thicknesses of the respective films are preferably N times quarter of the center wavelength and N times half of the center wavelength.

Furthermore, the optical interference films may also be multilayer films composed of triple or more-layer films, for controlling the reflectance at a low level in a far wider wavelength range. A constituent material for the optical interference films according to the present invention can be any material out of organic monomolecular substances, organic polymers, and inorganic metal oxides that can achieve the appropriate refractive index and film thickness determined on the basis of the above formulas, and it is preferable to use a sol-gel material being a polycondensate of a metal alkoxide. The sol-gel material is obtained by polycondensation of the metal alkoxide in an organic solvent in the presence of an acidic compound or a basic compound.

The acidic compound can be one selected, for example, from mineral acids such as nitric acid, hydrochloric acid, and so on, and organic acids such as oxalic acid, acetic acid, and so on. The basic compound can be, for example, ammonia or the like. Specific examples of the above metal alkoxide include: tetraalkoxysilanes such as tetramethoxysilane, tetraethoxysilane, tetrapropoxysilane, tetrabutoxysilane, and so on, trialkoxysilanes such as methyltrimethoxysilane, methyltriethoxysilane, ethyltrimethoxysilane, ethyltriethoxysilane, propyltrimethoxysilane, propyltriethoxysilane, butyltrimethoxysilane, butyltriethoxysilane, pentyltrimethoxysilane, pentyltriethoxysilane, hexyltrimethoxysilane, hexyltriethoxysilane, heptyltrimethoxysilane, heptyltriethoxysilane, octyltrimethoxysilane, octyltriethoxysilane, stearyltrimethoxysilane, stearyltriethoxysilane, vinyltrimethoxysilane, vinyltriethoxysilane, 3-chloropropyltrimethoxysilane, 3-chloropropyltriethoxysilane, 3-hydroxypropyltrimethoxysilane, 3-hydroxypropyltriethoxysilane, 3-glycidoxypropyltrimethoxysilane, 3-glycidoxytriethoxysilane, 3-methacryloxytrimethoxysilane, 3-methacryloxytriethoxysilane, phenyltrimethoxysilane, phenyltriethoxysilane, trifluoropropyltrimethoxysilane, trifluoropropyltriethoxysilane, and so on, and dialkoxysilanes such as dimethyldimethoxysilane, dimethyldiethoxysilane, and so on; titanium tetraalkoxide compounds such as titanium tetraethoxide, titanium tetrapropoxide, titanium tetrabutoxide, and so on; zirconium tetraalkoxide compounds such as zirconium tetraethoxide, zirconium tetrapropoxide, zirconium tetrabutoxide, and so on; aluminum trialkoxide compounds such as aluminum tributoxide, aluminum triisopropoxide, aluminum triethoxide, and so on; barium dialkoxide compounds such as barium diethoxide and the like; tantalum pentaalkoxide compounds such as tantalum pentapropoxide, tantalum-pentabutoxide, and so on; cerium tetraalkoxide compounds such as cerium tetramethoxide, cerium tetrapropoxide, and so on; yttrium trialkoxide compounds such as yttrium tripropoxide and the like; niobium pentaalkoxide compounds such as niobium pentamethoxide, niobium pentaethoxide, niobium pentabutoxide, and so on; and cadmium dialkoxide compounds such as cadmium dimethoxide, cadmium diethoxide, and so on; and these can be used singly or in combination of two or more compounds.

Among the alkoxysilanes as described above, it is preferable to use the tetraalkoxysilanes such as tetramethoxysilane, tetraethoxysilane, and so on, the trialkoxysilanes such as methyltrimethoxysilane, methyltriethoxysilane, ethyltrimethoxysilane, ethyltriethoxysilane, and so on, the titanium tetraalkoxide compounds, the zirconium tetraalkoxide compounds, the aluminum trialkoxide compounds, and the tantalum pentaalkoxide compounds.

Specific examples of the organic solvent used in the above polycondensation of the alkoxysilane and metal alkoxide, and in dissolution of metal salt include alcohols such as methanol, ethanol, propanol, butanol, and so on; ketones such as acetone, methyl ethyl ketone, and so on; aromatic hydrocarbons such as benzene, toluene, xylene, and so on; glycols such as ethylene glycol, propylene glycol, hexylene glycol, and so on; glycol ethers such as ethyl cellosolve, butyl cellosolve, ethyl carbitol, butyl carbitol, diethyl cellosolve, diethyl carbitol, and so on; N-methylpyrrolidone; and dimethylformamide; and these can be used singly or in mixture of two or more solvents. For the purposes of enhancing the long-term storage stability of the coating liquid and preventing uneven drying in applying the coating liquid onto the substrate, it is preferable to distil a low-boiling-point alcohol produced as a byproduct, after completion of hydrolysis, to increase the boiling point and viscosity of the solvent in the coating liquid.

Now, an example of a method of producing the transparent substrate for the organic electroluminescence device according to the present invention will be described. First, the aforementioned polycondensate of the metal alkoxide is dissolved in the aforementioned organic solvent to prepare a coating liquid.

This coating liquid is applied onto both sides of the transparent substrate by a coating method usually employed, such as a dip method, a spin coating method, a transfer printing method, a brush coating method, a roll coating method, a spraying method, or the like. From the viewpoint of mass productivity, it is preferable to employ the dip method by which the coating liquid can be smoothly applied onto both sides in a single operation and which can readily achieve application even over a large area. The resultant coating films, if made from the metal alkoxide, are dried at a temperature of 50 to 80°C and thereafter baked at a temperature of at least 100°C, preferably 100 to 500°C, for 0.5 to 1 hour, though the conditions depend on the material. This thermal curing can be conducted with use of equipment such as an oven, a hot plate, or the like.

Then the transparent substrate provided with the coating films is subjected to smoothing, if necessary, by a method such as polishing, pressing, application of a transparent planarizing film, or the like.

Although the case of the single-layer films was described above, the optical interference films of multiple layers can be formed by repeating the steps as described above. In the case of the optical interference films of multiple layers, it is a matter of course that the compositions, the film thicknesses, and the refractive indices of the respective layers constituting the optical interference films may be determined independently of each other.

The present invention will be explained below in further detail with examples, and these should be considered merely as illustrative but not restrictive on the present invention.

EXAMPLE 1

A silica-base sol-gel coating material (trade name LR-201A manufactured by NISSAN CHEMICAL INDUSTRIES, LTD.) was applied onto both sides of a glass-substrate by the dip method so as to form a film in a thickness of 103 nm on each side. This substrate was heated to bake at 510°C in an oven for 30 minutes. The substrate was taken out from the oven and the refractive index of the coating films was measured and found to be 1.26. Furthermore, the reflectance of this substrate for light at the wavelength of 550 nm was measured and found to be 2%. Since the reflectance of a glass substrate obtained without the present treatment was 4%, it was confirmed that the reflectance was decreased by the present treatment.

EXAMPLE 2

(Silica plus inorganic oxide)-base sol-gel coating materials (trade names H-7000, H-1000, and LR-202 manufactured by NISSAN CHEMICAL INDUSTRIES, LTD.) were laminated on both sides of the glass substrate by the dip method so as to form films in a thickness of 103 nm. This substrate was heated to bake at 510°C in the oven for 30 minutes. The substrate was taken out from the oven and the reflectance of the substrate for light at the wavelength of 550 nm was measured and found to be 0.3%. Since the reflectance of the glass substrate obtained without this treatment was 4%, it was confirmed that the reflectance was decreased by this treatment.

EXAMPLE 3

Organic electroluminescence devices were formed using the transparent substrates with the-optical interference layers obtained by above Examples 1 and 2, and the transparent substrate without the optical interference layers as a comparative example. An indium-tin oxide (ITO) layer was formed as a transparent electrode in the thickness of 100 nm by sputtering on one of the optical interference layers of each transparent substrate. At this time the sheet resistance was 20 $\Omega/cm^2$.

The following layers were successively formed on the surface of the transparent electrode: a hole-transporting layer in a thickness of 70 nm of an oligoaniline derivative described in Japanese Patent Application No. 2000-341775 previously filed by the present applicant (one obtained by dissolving an aniline pentamer in DMF and doping it with 3-fold mol equivalent of 5-sulfosalicylic acid); a light-emitting layer in a thickness of 50 nm of N,N'-bis(1-naphthyl)-N,N'-diphenyl-1,1'-bisphenyl-4,4'-diamine ($\alpha$-NPD); and an electron-transporting layer in a thickness of 50 nm of tris(8-hydroxyquinoline)aluminum (Alq$_3$). Then a magnesium-silver alloy was evaporated to form a cathode. In this case the thickness of the cathode was 200 nm.

A voltage of 10 V was applied between both electrodes of the organic electroluminescence devices formed in this manner, to measure the quantity of emission from the front face of the transparent substrate. The measured values of the devices formed with the transparent substrates of Examples 1 and 2 were compared relative to that of the comparative example defined as 1.

As a result, the device of Example 1 demonstrated the value of 1.2, and the device of Example 2 the value of 1.3, and it was confirmed from the result that the use of the transparent substrate according to the present invention significantly increased the luminance of surface emission from the organic electroluminescence devices of conventional structure.

INDUSTRIAL APPLICABILITY

As detailed above, the substrate for the organic electroluminescence device according to the present invention is excellent in mass productivity, and, by constructing the device using the substrate, it is feasible to fabricate the organic electroluminescence device with improved light extraction efficiency to the outside.

**Claims**

1. A transparent substrate for an organic electroluminescence device, wherein an optical interference film comprising at least one layer having such a refractive index and a film thickness as to reduce a quantity of reflection of light emitted from a light-emitting layer is provided on both sides of the transparent substrate.

2. The transparent substrate according to Claim 1, wherein the optical interference film has a refractive index of from 1.1 to 2.3 and a film thickness of from 10 to 25,000 nm.

3. The transparent substrate according to Claim 1 or 2, wherein the optical interference film is a multilayer film comprising a high refractive index film and a low refractive index film, or a multilayer film comprising films of different thicknesses.

4. The transparent substrate according to Claim 1, 2, or 3, wherein the optical interference film is one obtained by applying a sol-gel material of a metal oxide onto the transparent substrate and baking the material.

5. The transparent substrate according to Claim 4, wherein the sol-gel material of the metal oxide is one resulting from polycondensation of a metal alkoxide in an organic solvent in the presence of an acidic compound or a basic compound.

6. The transparent substrate according to Claim 5, wherein the metal alkoxide is an alkoxysilane, or a tetraalkoxide compound of titanium, zirconium, aluminum, or tantalum.

7. The transparent substrate according to any one of Claims 1 to 6, wherein the optical interference film is one obtained by forming a film of a sol-gel material of a metal oxide on both sides of the transparent substrate by a dip method and baking the film.

8. The transparent substrate according to any one of Claims 1 to 7, wherein the transparent substrate is a silica glass, a soda glass, or an organic film.

9. An organic electroluminescence device comprising the transparent substrate as defined in any one of Claims 1 to 8.

Fig. 1

Fig. 2

Fig. 3

## INTERNATIONAL SEARCH REPORT

| | International application No. |
|---|---|
| | PCT/JP02/09372 |

**A. CLASSIFICATION OF SUBJECT MATTER**
Int.Cl⁷ H05B33/02, 33/14, 3/22, G02B1/10, G09F9/00, 9/30

According to International Patent Classification (IPC) or to both national classification and IPC

**B. FIELDS SEARCHED**

Minimum documentation searched (classification system followed by classification symbols)
Int.Cl⁷ H05B33/00-33/28, G02B1/10, G09F9/00

Documentation searched other than minimum documentation to the extent that such documents are included in the fields searched

| | | | |
|---|---|---|---|
| Jitsuyo Shinan Koho | 1940-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 10-270170 A (Sanyo Electric Co., Ltd.), 09 October, 1998 (09.10.98), Full text; all drawings (Family: none) | 1-9 |
| Y | JP 10-255978 A (Pioneer Electronic Corp.), 25 September, 1998 (25.09.98), Full text; all drawings (Family: none) | 1-9 |
| Y | JP 11-109328 A (Seiko Epson Corp.), 23 April, 1999 (23.04.99), Full text; all drawings (Family: none) | 4-7 |

☐ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 October, 2002 (25.10.02) | 12 November, 2002 (12.11.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

9